# EUROPEAN PATENT SPECIFICATION

(11) **EP 1 986 479 B1**
(45) Date of publication and mention of the grant of the patent: **20.03.2013**
(21) Application number: 08153463.8
(22) Date of filing: 27.03.2008
(51) Int. Cl.: H05K 3/34, G01R 15/14, H05K 1/11, G01R 1/20

(54) **Wiring substrate and current detection device**
Anschlusssubstrat und Stromerkennungsvorrichtung
Substrat de câblage et dispositif de détection de courant

(30) Priority: 27.04.2007 JP 2007118731
(43) Date of publication of application: 29.10.2008
(73) Proprietor: OMRON Automotive Electronics Co., Ltd., Komaki, Aichi 485-0802 (JP)
(72) Inventor: Nagashima, Atsushi c/o Omron Corporation, Kyoto-shi Kyoto 600-8530 (JP)
(74) Representative: Kilian Kilian & Partner

(56) References cited:
- EP-A2- 1 313 109
- GB-A- 2 361 360
- JP-A- 8 115 802

## Description

### BACKGROUND OF THE INVENTION

### 1. Field of the Invention

The present invention relates to a wiring substrate mounted with a shunt resistor for current detection of an electronic circuit, and a current detection device equipped with the wiring substrate.

### 2. Description of the related art

Conventionally, a shunt resistor is incorporated in the middle of a line through which the current of the electronic circuit flows, and the current is detected based on the voltage drop by the shunt resistor. In Japanese Patent Application Laid-Open No. 2002-5968, two lands for soldering both ends of the shunt resistor and voltage measurement wiring patterns pulled out from one end in a direction perpendicular to the direction a current to be detected of each land flows are arranged on a substrate, where the voltage difference among the terminals of each of the wiring patterns is detected by a current detection circuit, and the current to be detected is calculated from the voltage difference and a current conversion graph. The current detection circuit includes those described in Japanese Patent Application Laid-Open No. 2003-121477, Japanese Patent Application Laid-Open No. 2003-121478, and Japanese Patent Application Laid-Open No. 2003-121481. The current detection circuits of Japanese Patent Application Laid-Open No. 2003-121478 and Japanese Patent Application Laid-Open No. 2003-121481 are contrived in an aim of enhancing the detection accuracy of the current to be detected.

In Japanese Patent Application Laid-Open No. 2003-232814, a wiring pattern for detecting the potential difference between both ends of the shunt resistor is pulled out from a location at where the current to be detected of each land mounted with both ends of the shunt resistor barely flows, or from an outer edge of each land positioned on an extended line of a wiring pattern for flowing the current to be detected connected to each land in order to enhance the detection accuracy of the current to be detected. Furthermore in Japanese Patent Application Laid-Open No. 2002-372551, Japanese Patent Application Laid-Open No. 2002-372550, Japanese Patent Application Laid-Open No. 2003-121477, Japanese Patent Application Laid-Open No. 2003-121478, and Japanese Patent Application Laid-Open No. 2003-121481, the wiring patterns for detecting the potential different of both ends of the shunt resistor are pulled out in a direction of approaching each other from the opposing outer edges of each land mounted with both ends of the shunt resistor, and thereafter, bent at right angles and pulled towards the side.

Generally, both ends of the shunt resistor are soldered to the land of the substrate, but if cracks form in the solder between the shunt resistor and the wiring pattern, the wiring path for detecting the current to be detected changes and the resistance value of the wiring path changes, whereby the potential difference in the shunt resistor and the current to be detected cannot be accurately detected. In particular, if the area of the land is only slightly larger than the area of the surface of the shunt resistor contacting the land as in Japanese Patent Application Laid-Open No. 2002-5968, Japanese Patent Application Laid-Open No. 2002-372551, and Japanese Patent Application Laid-Open No. 2002-372550, the solder fillet formed from the shunt resistor to the land is small, the soldering strength is low, and soldering cracks are likely to form.

In view of solving the above problems, it is an object of the present invention to provide a wiring substrate enabling accurately detection of the potential difference in the shunt resistor and the current to be detected without being influenced by soldering, and a current detection device.
Further, form EP 1 313 109 A2, a wiring substrate according to the preamble of claim 1 is known.

### SUMMARY OF THE INVENTION

The present invention relates to a wiring substrate including a land mounted with each rectangular surface of a shunt resistor, which has the rectangular surface at each of both ends thereof and has a central part floating with respect to the rectangular surfaces, and a wiring pattern for detecting a potential difference between the both ends of the shunt resistor pulled out from the land; and a current connection device including the shunt resistor, the wiring substrate, and a current detection circuit for detecting the potential difference between the both ends of the shunt resistor through the wiring pattern and detecting a current flowing to an electronic circuit formed on the wiring substrate based on the potential difference, respectively having the following configuration.
The land is configured by a first land and a second land each having a rectangular portion and being arranged at a predetermined interval with a virtual central line as a center, a third land having an area smaller than that of the first land and being arranged at one end of a direction parallel to the central line of the first land to be connected to the first land, and a fourth land having an area smaller than that of the second land and being arranged at one end of a direction parallel to the central line of the second land to be connected to the second land.
The wiring pattern is configured by a first wiring pattern connected to the third land and pulled out from the third land towards the fourth land, a second wiring pattern connected to the fourth land and pulled out from the fourth land towards the third land, a third wiring pattern connected to the first wiring pattern and pulled out in one direction parallel to the central line, and a fourth wiring connected to the second wiring pattern and pulled out in one direction parallel to the central line.

Accordingly, large part of each of the rectangular surfaces of the shunt resistor is mounted on and soldered to the first land and the second land each having a large area, and the solder fillet formed from the shunt resistor to the first land and the second land is enlarged, thereby increasing the solder strength. Thus cracks are less likely to be formed in the solder between the shunt resistor and the wiring pattern, the wiring path for detecting the current to be detected and the resistance value of the wiring path do not change, and the potential difference between the both ends of the shunt resistor and the current to be detected flowing through the electronic circuit can be accurately detected. Since the wiring pattern for detecting potential difference in the shunt resistor is pulled out from the third land and the fourth land towards the fourth land and the third land, and then pulled out in one direction away from the third land and the fourth land, the wiring path for detecting the current to be detected, that is, the wiring patterns can be separated from the wiring path through which the current to be detected flows, that is, the path from the land on one side of the central line to the land on the other side through the shunt resistor. Thus, the current to be detected does not flow into the wiring patterns, and the current to be detected can be accurately detected based on the potential difference between the both ends of the shunt resistor.

Further, in the wiring substrate of the present invention, the shunt resistor is soldered to the respective lands with one of the rectangular surfaces of the shunt resistor mounted on the first land and the third land, and the other rectangular surface mounted on the second land and the fourth land.

Therefore, the current to be detected flows from the first land and the third land or the second land and the fourth to the second land and the fourth land or the first land and the third land through the shunt resistor, and does not flow into the wiring pattern, whereby the current to be detected can be accurately detected based on the potential difference between the both ends of the shunt resistor.

Further, in the wiring substrate of the present invention, each of the rectangular surfaces of the shunt resistor is mounted on the respective lands so that an edge on a central part side of each of the rectangular surfaces of the shunt resistor contacts an edge on the central line side of the third land and the fourth land and a virtually extended line extending from the edge towards the first land and the second land.

Therefore, the first land and the second land are widened towards the central line side from the edges on the central line side of the third land and the fourth land, and the areas of the first land and the second land are made larger than the areas of the rectangular surfaces of the shunt resistor. Thus, the solder fillet formed from the shunt resistor to the first land and the second land can be enlarged to further increase the soldering strength, whereby generation of solder cracks is prevented. The generated heat of the shunt resistor that is generated when the current to be detected flows is radiated by the first land and the second land, whereby the resistance value of the shunt resistor is prevented from changing. Therefore, the potential difference between the both ends of the shunt resistor and the current to be detected flowing through the electronic circuit can be accurately detected continuously.

Further, in the wiring substrate of the present invention, a solder fillet is formed from a portion of the shunt resistor floating from the first land and the second land to a portion on the central line side of the first land and the second land.

Therefore, since the solder fillet is large, the solder strength between the shunt resistor and each land becomes higher, and generation of solder cracks is more reliably prevented.

Moreover, in the wiring substrate of the present invention, an interval between the third land and the fourth land is larger than the interval between the first land and the second land.

Thus, the wiring patterns can be easily pulled out from the third land and the fourth land, and the degree of freedom of circuit design in the wiring substrate can be enhanced.

Further, in the wiring substrate of the present invention, the land and the wiring pattern are plane symmetric with the central line as the center.

The wiring path for detecting the current to be detected and the resistance value of the wiring path thus become the same on both sides of the central line, whereby the current to be detected can be easily and accurately detected based on the potential difference between the both ends of the shunt resistor detected through the wiring patterns without performing a complex correction or the like that takes variation in the lands and the wiring patterns into consideration. Moreover, the current to be detected can be easily and accurately detected even if the current to be detected is flowed from either side of the central line, whereby degree of freedom of arrangement and design of the lands, the wiring patterns, the electronic circuit, or the like in the wiring substrate can be enhanced.

Further, in the wiring substrate of the present invention, an interval between the first land and the first wiring pattern and an interval between the second land and the second wiring pattern are smaller than the interval between the first land and the second land.

Therefore, the first land and the second land are widened towards the first wiring pattern and the second wiring pattern, the areas of the first land and the second land are large, and the solder fillet formed from the shunt resistor to the first land and the second land is enlarged.

Moreover, in the wiring substrate of the present invention, a surface of each of the wiring patterns is insulated.

If the surface of each of the wiring patterns is not insulated, the solder is disposed on the wiring pattern and the shunt resistor and the wiring pattern tend to be joined by the solder when the mounting position of the shunt resistor with respect to the land is shifted towards the central line side or the solder amount for joining the shunt resistor and the land is large. Furthermore, since the width of the wiring pattern is small, cracks easily form in the solder thereby changing the wiring path for detecting the current to be detected and the resistance value of the wiring path, whereby the potential difference in the shunt resistor and the current to be detected may not be accurately detected. If the surface of each of the wiring patterns is insulated, the shunt resistor and the wiring pattern are reliably prevented from being joined by the solder even if the mounting position of the shunt resistor with respect to the land is shifted towards the central line side or the solder amount for joining the shunt resistor and the land is large. Thus, the wiring path for detecting the current to be detected and the resistance value of the wiring path do not change, and the potential difference between the both ends of the shunt resistor and the current to be detected flowing through the electronic circuit can be accurately detected without being influenced by soldering.

In the wiring substrate of the present invention, a depression is formed on an inner angle side of a connection part between the first wiring pattern and the third wiring pattern, and a depression is formed on an inner angle side of a connection part between the second wiring pattern and the fourth wiring pattern.

Therefore, of the wiring patterns can be pulled out from the location of the third land and the fourth land contacting the edges on the central part side of the rectangular surfaces of the shunt resistor to have the width of each of the wiring patterns constant, whereby the variation in the resistance value of the first wiring pattern and the third wiring pattern and the resistance value of the second wiring pattern and the fourth wiring pattern is eliminated, and the current to be detected can be easily and accurately detected without performing a complex correction etc. that takes such a variation into consideration.

According to the present invention, the solder fillet formed from the shunt resistor to the first land and the second land is enlarged to increase the solder strength, cracks do not form in the solder between the shunt resistor and the wiring pattern, and the wiring path for detecting the current to be detected and the resistance value of the wiring path do not change, whereby the potential difference between the both ends of the shunt resistor and the current to be detected flowing through the electronic circuit can be accurately detected without being influenced by the solder.

### BRIEF DESCRIPTION OF THE DRAWINGS

FIG. 1 shows a view of a current detection device;
FIG. 2 shows a plan view of main parts of a wiring substrate;
FIG. 3 shows a perspective view of the main parts of the wiring substrate;
FIG. 4 shows a perspective view of a state of a shunt resistor mounted on the wiring substrate;
FIG. 5 shows a cross sectional view of a state of the shunt resistor soldered to the wiring substrate;
FIG. 6 shows a cross sectional view of another state of the shunt resistor soldered to the wiring substrate; and
Fig. 7 shows a perspective view of the shunt resistor.

### DETAILED DESCRIPTION OF THE PREFERRED EMBODIMENTS

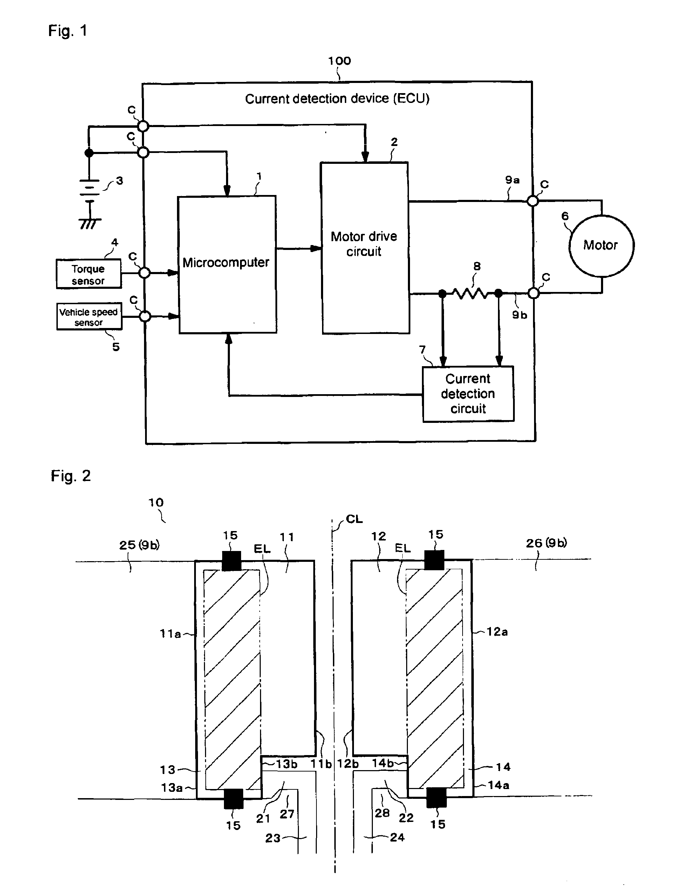

FIG. 1 shows a view of a current detection device 100 according to the present embodiment. The current detection device 100 is configured by an ECU (Electronic Control Unit) used in an electrically operated power steering system of an automobile, and the like. The current detection device 100 includes a microcomputer 1, a motor drive circuit 2, a current detection circuit 7, and a shunt resistor 8. A steering torque of a steering wheel detected by a torque sensor 4 and a vehicle speed (traveling speed) of the automobile detected by a vehicle speed sensor 5 are input to the microcomputer 1 via a connector C and a wiring. Power is supplied to the microcomputer 1 and the motor drive circuit 2 from a battery 3 via the connector C and the wiring.

The motor drive circuit 2 is configured by an H bridge circuit including four FETS, an FET gate drive circuit, and a step-up power supply. The motor 6 is configured by an electric motor. The motor 6 is rotation driven to supply assistance force to the steering of the steering wheel. The microcomputer 1 determines a current command value for driving the motor 6 based on the steering torque, the vehicle speed, and the like, and outputs the current command value to the motor drive circuit 2. The motor drive circuit 2 flows, in the forward direction or opposite direction, current of the level corresponding to the current command value to the motor 6 via the wiring 9a, 9b, the connector C and the like based on the current command value input from the microcomputer 1, and drives the motor 6 in PWM (Pulse Width Modulation) control. The shunt resistor 8 is arranged in the middle of one wiring 9b for flowing current from the motor drive circuit 2 to the motor 6. The current detection circuit 7 detects the potential difference between the both ends of the shunt resistor 8, detects the current value flowing to the motor 6 based on the potential difference and current conversion data (graph or function) stored in advance, and outputs the same to the microcomputer 1. The microcomputer 1 feedback controls the current flowing to the motor 6.

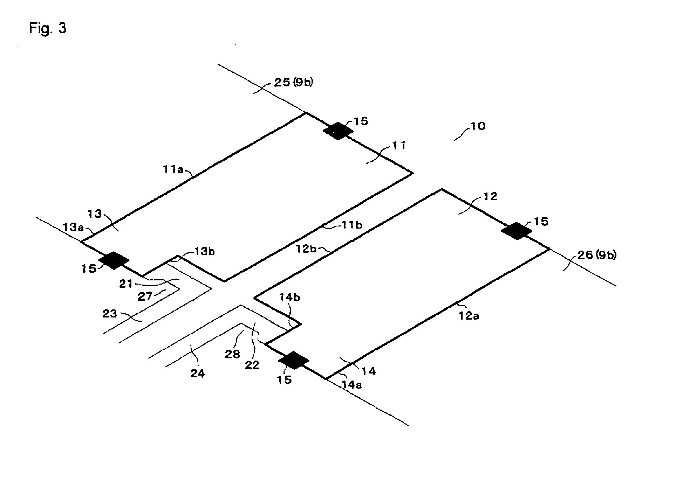

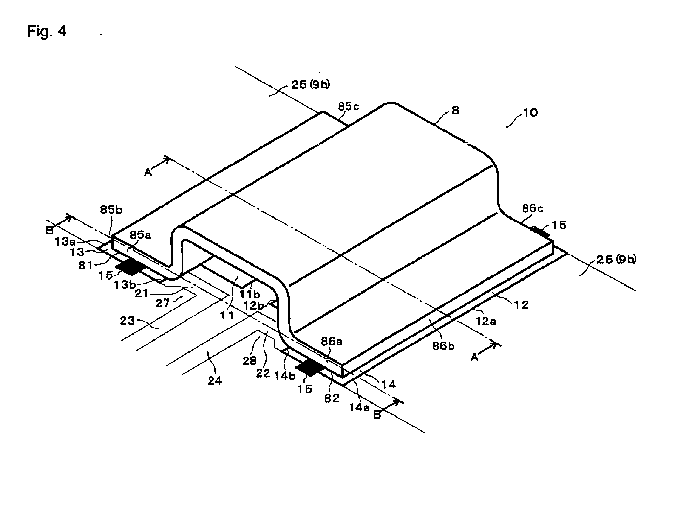

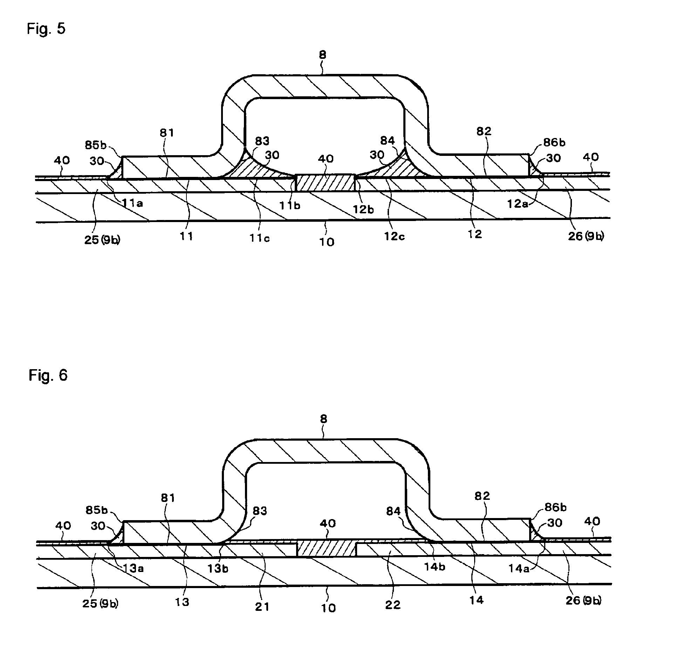

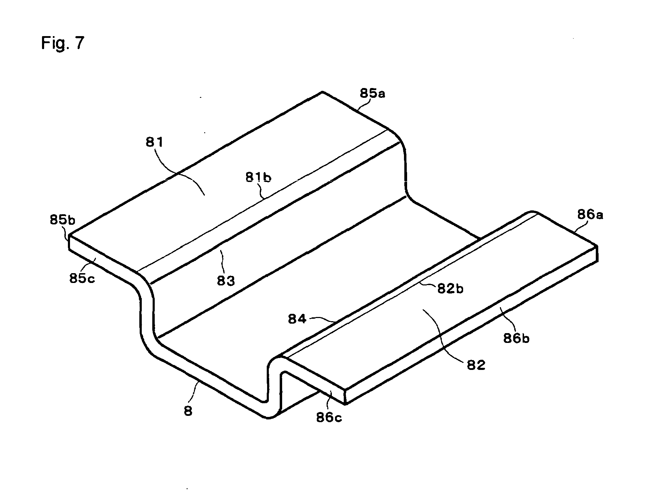

FIG. 2 shows a plan view of the main parts of a wiring substrate 10 according to the present embodiment. FIG. 3 shows a perspective view of the main parts of the wiring substrate 10. FIG. 4 shows a perspective view showing a state of the shunt resistor 8 mounted on the wiring substrate 10. FIGS. 5 and 6 show cross sectional views showing a state of the shunt resistor 8 soldered to the wiring substrate 10. Specifically, FIG. 5 shows a cross sectional view taken along line A-A of FIG. 4, and FIG. 6 shows a cross sectional view taken along line B-B of FIG. 4. FIG. 7 shows a perspective view of the shunt resistor 8.

The wiring substrate 10 is arranged in the current detection circuit 100. The wiring substrate 10 is mounted with the microcomputer 1, the motor drive circuit 2, the current detection circuit 7, the shunt circuit 8, and the wirings 9a, 9b of the current detection device 100 shown in FIG. 1. A plurality of lands 11 to 14 and wiring patterns 21 to 26 shown in FIGS. 2 and 3 are disposed on the surface of the wiring substrate 10. The lands 11 to 14 and the wiring patterns 21 to 26 are respectively formed by a conductor.

As shown in FIG. 2, the first land 11 and the second land 12 each has a rectangular portion, and is arranged at a predetermined interval with a virtual central line CL as the center. The areas of the first land 11 and the second land 12 are the same. The area of the third land 13 is smaller than that of the first land 11, and is arranged at one end (lower side in FIG. 2) in a direction parallel to the central line CL of the first land 11 and connected to the first land 11. The area of the fourth land 14 is smaller than that of the second land 12, and is arranged at one end (lower side in FIG. 2) in a direction parallel to the central line CL of the second land 12 and connected to the second land 12. The areas of the third land 13 and the fourth land 14 are the same. An edge 11a on the side opposite to the central line CL of the first land 11, and an edge 13a on the side opposite to the central line CL of the third land 13 coincide. An edge 12a on the side opposite to the central line CL of the second land 12 and an edge 14a on the side opposite to the central line CL of the fourth land 14 coincide. A concave part 15 formed by an insulator is arranged at the ends (lower side in FIG. 2) in a direction parallel to the central line CL of the third land 13 and the fourth land 14, and at the ends (upper side in FIG. 2) in a direction parallel to the central line CL of the first land 11 and the second land 12. The interval between the third land 13 and the fourth land 14 is greater than the interval between the first land 11 and the second land 12. The lands 11 to 14 form a land for mounting the shunt resistor 8.

The first land 11 and the third land 13 are arranged at one end of the fifth wiring pattern 25. The second land 12 and the fourth land 14 are arranged at one end of the sixth wiring pattern 26. The other ends (not shown) of the fifth wiring pattern 25 and the sixth wiring pattern 26 are respectively connected to the motor drive circuit 2 and the motor 6 shown in FIG. 1 by way of another wiring pattern (not shown), the connector C, or the like. The fifth wiring pattern 25 and the sixth wiring pattern 26 configure one part of one wiring 9b for flowing the current from the motor drive circuit 2 to the motor 6.

As shown in FIG. 2, the first wiring pattern 21 is connected to an edge 13b on the central line CL side of the third land 13, and is pulled out from the third land 13 towards the fourth land 14. The second wiring pattern 22 is connected to an edge 14b on the central line CL side of the fourth land 13, and is pulled out from the fourth land 14 towards the third land 13. The third wiring pattern 23 is connected to the first wiring pattern 21, and is pulled in one direction (lower side in FIG. 2) parallel to the central line CL. The fourth wiring pattern 24 is connected to the second wiring pattern 22, and is pulled in one direction (lower side in FIG. 2) parallel to the central line CL. The ends (not shown) of the third wiring pattern 23 and the fourth wiring pattern 24 are respectively connected to the current detection circuit 7 (shown in FIG. 1) by way of other wiring patterns etc. (not shown). The wiring patterns 21 to 24 form a wiring pattern for detecting the potential different of both ends of the shunt resistor 8.

As shown in FIG. 2 and FIG. 3, a depression 27 is formed on the inner angle side of a connection part between the first wiring pattern 21 and the third wiring pattern 23. A depression 28 is formed on the inner angle side of a connection part between the second wiring pattern 22 and the fourth wiring pattern 24. The widths of the first wiring pattern 21 and the second wiring pattern 22 are made the same as the widths of the third wiring pattern 23 and the fourth wiring pattern 24 by forming the depressions 27, 28. The interval between the first land 11 and the first wiring pattern 21 and the interval between the second land 12 and the second wiring pattern 22 are smaller than the interval between the first land 11 and the second land 12. The lands 11 to 14 and the wiring patterns 21 to 26 are plane symmetric with respect to the central line CL. Portions other than the lands 11 to 14, that is, the periphery of the lands 11 to 14, the space between the lands 11 to 14, and the surface of each of the wiring patterns 21 to 26 are covered by a resist film 40 (shown in FIG. 5 and FIG. 6) so as to be insulated.

As shown in FIG. 7, the shunt resistor 8 has rectangular surfaces 81, 82 formed at both ends and a central part floating with respect to the rectangular surfaces 81, 82. As shown in FIG. 4 to FIG. 6, one rectangular surface 81 of the shunt resistor 8 is mounted on the first land 11 and the third land 13, and the other rectangular surface 82 is mounted on the second land 12 and the fourth land 14. Specifically, each of the rectangular surfaces 81, 82 of the shunt resistor 8 is mounted on each land 11 to 14 so that the edges 81 b, 82b (shown in FIG. 7) on the central part side of each of the rectangular surfaces 81, 82 of the shunt resistor 8 contact the edges 13b, 14b (shown in FIG. 2) on the central line CL side of the third land 13 and the fourth land 14, and the virtually extended line EL (shown in FIG. 2) extending from the edges 13b, 14b respectively towards the first land 11 and the second land 12. The hatching portion of rectangular shape surrounded by a chain double-dashed line on the lands 11 to 14 of FIG. 2 is the contacting portion of the rectangular surfaces 81, 82 of the shunt resistor 8 with respect to the lands 11 to 14. The edges other than the edges 81 b, 82b of each of the rectangular surfaces 81, 82 of the shunt resistor 8 are spaced apart from the edge of the opposing land 11 to 14 by a predetermined interval. The concave part 15 is used for positioning when mounting the shunt resistor 8 on the lands 11 to 14 as described above. Specifically, the concave part 15 is detected through image recognition, the cream solder is applied to an appropriate position on the lands 11 to 14 with the concave part 15 as a marker, and thereafter, the shunt resistor 8 is mounted to an appropriate position on the lands 11 to 14. Subsequently, when the solder melted through heat is cooled, the solder does not wet spread on the lands 11 to 14 and flow into the concave part 15, and shift of the shunt resistor 8 from the appropriate position is inhibited by the concave part 15.

After applying the cream solder on each land 11 to 14 of the wiring substrate 10, each of the rectangular surfaces 81, 82 of the shunt resistor 8 is mounted on the lands 11 to 14 as shown in FIG. 4 etc., and thereafter, the wiring substrate 10 and the shunt resistor 8 are once heated with a reflow bath etc. and cooled, so that the shunt resistor 8 is soldered to the lands 11 to 14 as shown in FIG. 5 and FIG. 6. At this point, as shown in FIG. 5, a large solder fillet 30 forms from portions 83, 84 of the shunt resistor 8 floating from the first land 11 and the second land 12 to portions 11c, 12c on the central line CL side of the first land 11 and the second land 12 that are not contacting the rectangular surfaces 81, 82. As shown in FIG. 5 and FIG. 6, the solder fillet 30 also forms from end faces 85a to 85c, 86a to 86c (shown in FIG. 4 to FIG. 7) orthogonal to each of the rectangular surfaces 81, 82 of the shunt resistor 8 to the portion of the lands 11 to 14 proximate to the end faces 85a to 85c, 86a to 86c that are not contacting the rectangular surfaces 81, 82. The shunt resistor 8 and the wiring patterns 21 to 26 will not be soldered since the periphery of the lands 11 to 14, the space between the lands 11 to 14, and the surface of each of the wiring patterns 21 to 26 are insulated.

When the shunt resistor 8 is soldered to the lands 11 to 14 as described above, the wiring 9b shown in FIG. 1 becomes to allow a current to flow therethrough, whereby the drive current of the motor 6 flows through the wiring patterns 25, 26 and the shunt resistor 8. The potential difference between the both ends of the shunt resistor 8 is then detected through the wiring patterns 21 to 24 by the current detection circuit 7, and the current value flowing to the motor 6 is detected based on the potential difference and the current conversion data stored in advance.

Therefore, the soldering strength can be increased by mounting and soldering large part of each of the rectangular surfaces 81, 82 of the shunt resistor 8 to the first land 11 and the second land 12 having a large area, and enlarging the solder fillet 30 formed from the shunt resistor 8 to the first land 11 and the second land 12. Thus, cracks are less likely to form in the solder between the shunt resistor 8 and the wiring patterns 21, 22, and the potential difference between the both ends of the shunt resistor 8 and the current to be detected can be accurately detected without changing the wiring path for detecting the current to be detected (drive current of the motor 6) and the resistance value of the wiring path, and without being influenced by soldering.

As shown in the cross sectional view of FIG. 6, the resist film 40 exists between the portions 83, 84 of the shunt resistor 8 and the wiring patterns 21, 22. Thus, the fillet does not form between the portions 83, 84 of the shunt resistor 8 and the wiring patterns 21, 22. Since the fillet does not exist, cracks do not form near the portions 83, 84 of the shunt resistor 8. That is, the fillet does not influence current detection near the portions 83, 84 of the shunt resistor 8 and the wiring patterns 21, 22, and current can be accurately detected.

Since the wiring patterns 21 to 24 for detecting potential difference in the shunt resistor 8 are pulled out from the third land 13 and the fourth land 14 towards the fourth land 14 and the third land 13, and then pulled out in one direction away from the third land 13 and the fourth land 14, the wiring path for detecting the current to be detected, that is, the wiring patterns 21 to 24 can be separated from the wiring path through which the current to be detected flows, that is, the path from the land on one side of the central line CL (first land 11 and third land 13 or second land 12 and fourth land 14) to the land on the other side (second land 12 and fourth land 14 or first land 11 and third land 13) through the shunt resistor 8. Thus, the current to be detected does not flow into the wiring patterns 21 to 24, and the current to be detected can be accurately detected based on the potential difference between the both ends of the shunt resistor 8.

The shunt resistor 8 is mounted on the lands 11 to 14 so that each of the rectangular surfaces 81, 82 of the shunt resistor 8 contacts the hatching portion in FIG. 2, whereby the first land 11 and the second land 12 are widened towards the central line CL side from the edges 13b, 14b on the central line CL side of the third land 13 and the fourth land 14, and the areas of the first land 11 and the second land 12 are made larger than the areas of the rectangular surfaces 81, 82. Thus, as shown in FIG. 5, the solder fillet 30 formed from the shunt resistor 8 towards the central line CL side of the first land 11 and the second land 12 can be enlarged to further increase the soldering strength, whereby generation of solder cracks is further prevented. The generated heat of the shunt resistor 8 that is generated when the current to be detected flows is radiated by the first land 11 and the second land 12, whereby the resistance value of the shunt resistor 8 is prevented from changing. Therefore, the potential difference between the both ends of the shunt resistor 8 and the current to be detected can be accurately detected continuously.

Since the interval between the third land 13 and the fourth land 14 is larger than the interval between the first land 11 and the second land 12, the wiring patterns 21 to 24 can be easily pulled out from the third land 13 and the fourth land 14, and the degree of freedom of circuit design in the wiring substrate 10 can be enhanced.

Furthermore, since the lands 11 to 14 and the wiring patterns 21 to 26 are plane symmetric with the central line CL as the center, the wiring path for detecting the current to be detected and the resistance value of the wiring path become the same on both sides of the central line CL. Thus, the current to be detected can be easily and accurately detected based on the potential difference between the both ends of the shunt resistor 8 detected through the wiring patterns 21 to 24 without performing a complex correction or the like that takes variation in the lands 11 to 14 and the wiring patterns 21 to 26 into consideration. Moreover, the current to be detected can be easily and accurately detected even if the current to be detected is flowed from either side (wiring pattern 25 side or wiring pattern 26 side) of the central line CL, whereby degree of freedom of arrangement and design of the lands 11 to 14, the wiring patterns 21 to 26, the electronic circuit, or the like in the wiring substrate 10 can be enhanced.

Since the interval between the first land 11 and the first wiring pattern 21 and the interval between the second land 12 and the second wiring pattern 22 are smaller than the interval between the first land 11 and the second land 12, the first land 11 and the second land 12 can be extended in the direction of the first wiring pattern 21 and the second wiring pattern 22 thereby increasing the area of the first land 11 and the second land 12. Thus, the solder fillet 30 formed from the shunt resistor 8 to the first land 11 and the second land 12 can be enlarged.

If the surface of the wiring patterns 21 to 24 is not insulated, the solder is disposed on the wiring patterns 21 to 24 and the shunt resistor 8 and the wiring patterns 21 to 24 tend to be joined by the solder when the mounting position of the shunt resistor 8 with respect to the lands 11 to 14 is shifted towards the central line CL side or the solder amount for joining the shunt resistor 8 and the lands 11 to 14 is large. Furthermore, since the width of the wiring patterns 21 to 24 is small, cracks easily form in the solder thereby changing the wiring path for detecting the current to be detected and the resistance value of the wiring path, whereby the potential difference in the shunt resistor 8 and the current to be detected may not be accurately detected. If the surface of the wiring patterns 21 to 24 is insulated, the shunt resistor 8 and the wiring patterns 21 to 24 are reliably prevented from being joined by the solder even if the mounting position of the shunt resistor 8 with respect to the lands 11 to 14 is shifted towards the central line side or the solder amount for joining the shunt resistor 8 and the lands 11 to 14 is large. Thus, the wiring path for detecting the current to be detected and the resistance value of the wiring path do not change, and the potential difference between the both ends of the shunt resistor 8 and the current to be detected can be accurately detected without being influenced by soldering.

Furthermore, since the depressions 27, 28 are formed on the inner angle side of the connection part of the wiring patterns 21 to 24, the wiring patterns 21, 22 can be pulled out from the location of the third land 13 and the fourth land 14 contacting the edges 81 b, 82b on the central part side of the rectangular surfaces 81, 82 of the shunt resistor 8 to have the width of each of the wiring patterns 21 to 24 constant. Thus, the variation in the resistance value of the first wiring pattern 21 and the third wiring pattern 23, and the resistance value of the second wiring pattern 22 and the fourth wiring pattern 24 is eliminated, and the current to be detected can be easily and accurately detected without performing a complex correction etc. that takes such a variation into consideration.

In the embodiment described above, an example of applying the present invention to the wiring substrate 10 and the current detection device 100 for detecting the motor drive current in the electrically operated power steering system has been described, but the present invention is also applicable to a current detection device and a wiring substrate for detecting current flowing to other electronic circuits.

## Claims

1. A wiring substrate comprising: a land (11, 12, 13, 14) mounted with each rectangular surface (81, 82) of a shunt resistor (8) which has the rectangular surface (81, 82) at each of both ends thereof and has a central part floating with respect to the rectangular surfaces (81, 82); and a wiring pattern (21, 22, 23, 24) for detecting a potential difference between the both ends of the shunt resistor (8) pulled out from the land (11, 12, 13, 14); wherein
the land (11,12,13,14) Is configured by:
a first land (11) and a second land (12) each having a rectangular portion and being arranged at a predetermined interval with a virtual central line (CL) as a center;
a third land (13) to be connected to the first land (11), the third land (13) having an area smaller than that of the first land (11) and being arranged at one end in a direction parallel to the central line; and
a fourth land (14) to be connected to the second land (12), the fourth land (14) having an area smaller than that of the second land (12) and being arranged at one end in a direction parallel to the central line
, and
the wiring pattern is configured by:
a first wiring pattern (21) connected to the third land (13) and pulled out from the third land (13) towards the fourth land (14);
a second wiring pattern (22) connected to the fourth land (14) and pulled out from the fourth land (14) towards the third land (13);
a third wiring pattern (23) connected to the first wiring pattern (21) and pulled out in one direction parallel to the central line (CL); and
a fourth wiring pattern (24) connected to the second wiring pattern (22) and pulled out in one direction parallel to the central line (CL); **characterized in that**
a surface of each of the wiring patterns (21, 22, 23, 24) is Insulated,
an Interval between the third land (13) and the fourth land (14) is larger than the predetermined interval between the first land (11) and the second land (11), and
the shunt resistor (8) is soldered to the first land (11) and the third land (13) with one of the rectangular surfaces (81, 82) and to the second land (12) and the fourth land (14) with the other rectangular surface (81, 82), wherein each of the rectangular surfaces (81, 82) of the shunt resistor (8) is mounted on the respective lands (11, 12, 13, 14) so that an edge (81b, 82b) on a central part side of each of the rectangular surfaces (81, 82) of the shunt resistor (8) contacts an edge on the central line side of the third land (13) and the fourth land (14).

2. The wiring substrate according to claim 1, wherein a solder fillet (30) is formed from a portion of the shunt resistor (8) floating from the first land (11) and the second land (12) to a portion on the central line side of the first land (11) and the second land (12).

3. The wiring substrate according to claim 1, wherein the land (11, 12, 13, 14) and the wiring pattern are plane symmetric with the central line as the center.

4. The wiring substrate according to claim 1, wherein an interval between the first land (11) and the first wiring pattern (21) and an interval between the second land (12) and the second wiring pattern (22) are smaller than the interval between the first land (11) and the second land (12).

5. The wiring substrate according to claim 1, wherein a depression (27) is formed on an inner angle side of a connection part between the first wiring pattern (21) and the third wiring pattern (23), and a depression (28) is formed on an inner angle side of a connection part between the second wiring pattern (22) and the fourth wiring pattern (24).

6. A current detection device (100) comprising:
a wiring substrate according to one of the claims 1 to 5; and a current detection circuit (7) for detecting the potential difference between the both ends of the shunt resistor (8) through the wiring pattern (21, 22, 23, 24) and detecting a current flowing to an electronic circuit formed on the wiring substrate based on the potential difference.

## Patentansprüche

1. Verdrahtungssubstrat aufweisend: eine Anschlussfläche (11, 12, 13, 14), auf der jede rechteckige Oberfläche (81, 82) eines Messwiderstandes (8) befestigt ist, der die rechteckige Oberfläche (81, 82) an jedem seiner beiden Enden und einen unter Bezug auf die rechteckigen Oberflächen (81, 82) angehobenen zentralen Abschnitt aufweist; und ein aus der Anschlussfläche (11, 12, 13, 14) herausgezogenes Verdrahtungsmuster (21, 22, 23, 24) zur Detektion einer Potentialdifferenz zwischen den beiden Enden des Messwiderstandes (8); wobei
die Anschlussfläche (11, 12, 13, 14) aufgebaut ist durch:
eine erste Anschlussfläche (11) und eine zweite Anschlussfläche (12), die jeweils einen rechteckigen Abschnitt aufweisen und in einem vorbestimmten Abstand mit einer virtuellen Mittellinie (CL) als Mitte angeordnet sind;
eine mit der ersten Anschlussfläche (11) zu verbindenden dritten Anschlussfläche (13), wobei die dritte Anschlussfläche (13) eine kleinere Fläche als die der ersten Anschlussfläche (11) aufweist und an einem Ende in einer Richtung parallel zu der Mittellinie angeordnet ist; und
eine mit der zweiten Anschlussfläche (12) zu verbindenden vierten Anschlussfläche (14), wobei die vierte Anschlussfläche (14) eine kleinere Fläche als die der zweiten Anschlussfläche (12) aufweist und an einem Ende in einer Richtung parallel zu der Mittellinie angeordnet ist, und
das Verdrahtungsmuster aufgebaut ist durch:
ein erstes Verdrahtungsmuster (21), das mit der dritten Anschlussfläche (13) verbunden und aus der dritten Anschlussfläche (13) in Richtung der vierten Anschlussfläche (14) herausgezogen ist;
ein zweites Verdrahtungsmuster (22), das mit der vierten Anschlussfläche (14) verbunden und aus der vierten Anschlussfläche (14) in Richtung der dritten Anschlussfläche (13) herausgezogen ist;
ein drittes Verdrahtungsmuster (23), das mit dem ersten Verdrahtungsmuster (21) verbunden und in einer Richtung parallel zu der Mittellinie (CL) herausgezogen ist; und
ein viertes Verdrahtungsmuster (24), das mit dem zweiten Verdrahtungsmuster (22) verbunden und in einer Richtung parallel zu der Mittellinie (CL) herausgezogen ist; **dadurch gekennzeichnet, dass**
eine Oberfläche jeder der Verdrahtungsmuster (21, 22, 23, 24) isoliert ist,
ein Abstand zwischen der dritten Anschlussfläche (13) und der vierten Anschlussfläche (14) größer ist als der vorbestimmte Abstand zwischen der ersten Anschlussfläche (11) und der zweiten Anschlussfläche (11), und
der Messwiderstand (8) auf die erste Anschlussfläche (11) und die dritte Anschlussfläche (13) mit einer der rechteckigen Oberflächen (81, 82) und auf die zweite Anschlussfläche (12) und die vierte Anschlussfläche (14) mit der anderen rechteckigen Oberfläche (81, 82) gelötet ist, wobei jede der rechteckigen Oberflächen (81, 82) des Messwiderstandes (8) auf den entsprechenden Anschlussflächen (11, 12, 13, 14) derart befestigt ist, dass eine Kante (81b, 82b) auf einer Mittenabschnittsseite jeder der rechteckigen Oberflächen (81, 82) des Messwiderstandes (8) eine Kante auf der Mittellinienseite der dritten Anschlussfläche (13) und der vierten Anschlussfläche (14) berührt.

2. Verdrahtungssubstrat gemäß Anspruch 1, wobei eine Lötkehle (30) von einem Abschnitt des Messwiderstandes (8), der gegenüber der ersten Anschlussfläche (11) und der zweiten Anschlussfläche (12) abgehoben ist, zu einem Abschnitt auf der Mittellinienseite der ersten Anschlussfläche (11) und der zweiten Anschlussfläche (12) gebildet ist.

3. Verdrahtungssubstrat gemäß Anspruch 1, wobei die Anschlussfläche (11, 12, 13, 14) und das Verdrahtungsmuster ebensymmetrisch mit der Mittellinie als Mitte sind.

4. Verdrahtungssubstrat gemäß Anspruch 1, wobei ein Abstand zwischen der ersten Anschlussfläche (11) und dem ersten Verdrahtungsmuster (21) und ein Abstand zwischen der zweiten Anschlussfläche (12) und dem zweiten Verdrahtungsmuster (22) kleiner sind als der Abstand zwischen der ersten Anschlussfläche (11) und der zweiten Anschlussfläche (12).

5. Verdrahtungssubstrat gemäß Anspruch 1, wobei eine Vertiefung (27) auf einer Innenwinkelseite eines Verbindungsabschnittes zwischen dem ersten Verdrahtungsmuster (21) und dem dritten Verdrahtungsmuster (23) gebildet ist, und eine Vertiefung (28) auf einer Innenwinkelseite eines Verbindungsabschnittes zwischen dem zweiten Verdrahtungsmuster (22) und dem vierten Verdrahtungsmuster (24) gebildet ist.

6. Stromdetektionsvorrichtung (100) aufweisend:
ein Verdrahtungssubstrat gemäß einem der Ansprüche 1 bis 5;
und eine Stromdetektionsschaltung (7) zum Detektieren der Potentialdifferenz zwischen beiden Enden des Messwiderstandes (8) über das Verdrahtungsmuster (21, 22, 23, 24) und zum Detektieren eines Stromes, der zu einer elektronischen Schaltung, die auf dem Verdrahtungssubstrat gebildet ist, fließt, beruhend auf der Potentialdifferenz.

## Revendications

1. Substrat de câblage comprenant : une plage d'accueil (11, 12, 13, 14) équipée de chaque surface rectangulaire (81, 82) d'une résistance de dérivation (8) qui possède la surface rectangulaire (81, 82) à chacune de ses deux extrémités et possède une partie centrale flottant par rapport aux surfaces rectangulaires (81, 82) ; et un schéma de câblage (21, 22, 23, 24) servant à détecter une différence de potentiel entre les deux extrémités de la résistance de dérivation (8) sortant de la plage d'accueil (11, 12, 13, 14) ; dans lequel
la plage d'accueil (11, 12, 13, 14) est configurée par :
une première plage d'accueil (11) et une deuxième plage d'accueil (12) comportant chacune une partie rectangulaire et étant chacune placée à un intervalle prédéfini, une ligne centrale virtuelle (CL) servant de centre ;
une troisième plage d'acceuil (13) à relier à la première plage d'accueil (11), la troisième plage d'accueil (13) ayant une superficie inférieure à celle de la première plage d'accueil (11) et étant placée à une extrémité dans une direction parallèle à la ligne centrale ; et
une quatrième plage d'accueil (14) à relier à la deuxième plage d'accueil (12), la quatrième plage d'acceuil (14) ayant une superficie inférieure à celle de la deuxième plage d'accueil (12) et étant placée à une extrémité dans une direction parallèle à la ligne centrale, et
le schéma de câblage est configuré par :
un premier schéma de câblage (21) connecté à la troisième plage d'accueil (13) et sortant de la troisième plage d'accueil (13) vers la quatrième plage d'accueil (14) ;
un deuxième schéma de câblage (22) connecté à la quatrième plage d'accueil (14) et sortant de la quatrième plage d'accueil (14) vers la troisième plage d'accueil (13) ;
un troisième schéma de câblage (23) connecté au premier schéma de câblage (21) et sortant dans une direction parallèle à la ligne centrale (CL) ; et
un quatrième schéma de câblage (24) connecté au deuxième schéma de câblage (22) et sortant dans une direction parallèle à la ligne centrale (CL) ; **caractérisé en ce que**
une surface de chacun des schémas de câblage (21, 22, 23, 24) est isolée,
un intervalle entre la troisième plage d'accueil (13) et la quatrième plage d'accueil (14) est supérieur à l'intervalle prédéfini entre la première plage d'accueil (11) et la deuxième plage d'accueil (12), et
la résistance de dérivation (8) est soudée à la première plage d'accueil (11) et à la troisième plage d'accueil (13) par l'une des surfaces rectangulaires (81, 82) et à la deuxième plage d'accueil (12) et à la quatrième plage d'accueil (14) par l'autre surface rectangulaire (81, 82), chacune des surfaces rectangulaires (81, 82) de la résistance de dérivation (8) étant montée sur les plages d'accueil respectives (11, 12, 13, 14) de sorte qu'un bord (81b, 82b) situé sur un côté partie centrale de chacune des surfaces rectangulaires (81, 82) de la résistance de dérivation (8) entre en contact avec un bord situé sur le côté ligne centrale de la troisième plage d'accueil (13) et de la quatrième plage d'accueil (14).

2. Substrat de câblage selon la revendication 1, dans lequel un cordon de soudage (30) est formé à partir d'une partie de la résistance de dérivation (8) flottant depuis la première plage d'accueil (11) et de la deuxième plage d'accueil (12) jusqu'à une partie située sur le côté ligne centrale de la première plage d'accueil (11) et de la deuxième plage d'accueil (12).

3. Substrat de câblage selon la revendication 1, dans lequel la plage d'accueil (11, 12, 13, 14) et le schéma de câblage sont symétriques dans le plan, la ligne centrale servant de centre.

4. Substrat de câblage selon la revendication 1, dans lequel un intervalle entre la première plage d'accueil (11) et le premier schéma de câblage (21) et un intervalle entre la deuxième plage d'accueil (12) et le deuxième schéma de câblage (22) sont inférieurs à l'intervalle entre la première plage d'accueil (11) et la deuxième plage d'accueil (12).

5. Substrat de câblage selon la revendication 1, dans lequel un renfoncement (27) est formé sur un côté d'angle intérieur d'une partie de connexion entre le premier schéma de câblage (21) et le troisième schéma de câblage (23), et un renfoncement (28) est formé sur un côté d'angle intérieur d'une partie de connexion entre le deuxième schéma de câblage (22) et le quatrième schéma de câblage (24).

6. Dispositif de détection de courant (100) comprenant :
un substrat de câblage selon l'une des revendications 1 à 5 ; et un circuit de détection de courant (7) destiné à détecter la différence de potentiel entre les deux extrémités de la résistance de dérivation (8) par le biais du schéma de câblage (21, 22, 23, 24) et à détecter un courant circulant jusqu'à un circuit électronique formé sur le substrat de câblage sur la base de la différence de potentiel.
